# EUROPEAN PATENT APPLICATION

(11) **EP 4 826 393 A1**
(43) Date of publication of application: **21.10.2026**
(21) Application number: 24903458.8
(22) Date of filing: 21.11.2024
(51) Int. Cl.: G01R 1/06, G01R 1/067, G01R 31/26, H01L 21/66

(54) **PROBE**

(30) Priority: 12.12.2023 JP 2023209330
(71) Applicant: Kabushiki Kaisha Nihon Micronics, Musashino-shi Tokyo 180-8508 (JP)
(72) Inventor: FUKUSHI Naoki, Musashino-shi, Tokyo 180-8508 (JP); MATSUO Takuya, Musashino-shi, Tokyo 180-8508 (JP); TAKAHASHI Masayuki, Musashino-shi, Tokyo 180-8508 (JP); OMORI Toshinori, Musashino-shi, Tokyo 180-8508 (JP); NARA Yuto, Musashino-shi, Tokyo 180-8508 (JP)
(74) Representative: Berggren Oy
(86) International application number: PCT/JP2024/041351
(87) International publication number: WO 2025/126799

(57) **Abstract**

A probe (10) includes: a columnar body portion (11) extending in an axial direction; a tip portion (12) connected to one end of the body portion (11) and coming into contact with an inspection object in inspection; and a base end portion (13) connected to the other end of the body portion (11). The base end portion (13) includes a plurality of connection portions (130) each having a connecting portion (131) with elasticity and connected to the body portion (11), and a contact portion (132) having a first end connected to the connecting portion (131).

## Description

### TECHNICAL FIELD

The present invention relates to a probe used for inspection of electrical characteristics of an inspection object.

### BACKGROUND ART

An electrical connection device including a probe is used for inspection of electrical characteristics of an inspection object such as a semiconductor integrated circuit in a wafer state. In inspection using a probe, one end of the probe comes into contact with an electrode of the inspection object, and the other end of the probe comes into contact with a terminal (hereinafter referred to as "land") disposed on a substrate provided in the electrical connection device. The land is electrically connected to an inspection device such as a tester.

### CITATION LIST

### PATENT LITERATURE

Patent Literature 1: Japanese Patent Application Publication No. 2018-4260

### SUMMARY

In order to accurately inspect the electrical characteristics of an inspection object, it is necessary to stably electrically connect the inspection object and the land via a probe. An object of the present invention is to provide a probe capable of establishing a stable electrical connection between an inspection object and a land.

A probe according to an aspect of the present invention includes: a columnar body portion extending in an axial direction; a tip portion connected to one end of the body portion and coming into contact with an inspection object in inspection; and a base end portion connected to the other end of the body portion. The base end portion includes a plurality of connection portions each having a connecting portion with elasticity and connected to the body portion, and a contact portion having a first end connected to the connecting portion.

The present invention makes it possible to provide a probe that stabilizes an electrical connection between an inspection object and a land.

### BRIEF DESCRIPTION OF DRAWINGS

[FIG. 1] FIG. 1 is a schematic diagram illustrating a configuration of a probe according to a first embodiment.
[FIG. 2] FIG. 2 is a schematic diagram illustrating a configuration of a base end portion of the probe according to the first embodiment.
[FIG. 3] FIG. 3 is a schematic diagram illustrating a configuration of an electrical connection device including the probe according to the first embodiment.
[FIG. 4] FIG. 4 is a schematic diagram illustrating an example of arrangement of connecting portions of the probe according to the first embodiment.
[FIG. 5] FIG. 5 is a schematic diagram illustrating a configuration of an electrical connection device including a probe of a comparative example.
[FIG. 6] FIG. 6 is a schematic diagram illustrating a structure of a connecting portion of a probe according to a modified example of the first embodiment.
[FIG. 7] FIG. 7 is a schematic diagram illustrating another structure of a connecting portion of a probe according to the modified example of the first embodiment.
[FIG. 8] FIG. 8 is a schematic diagram illustrating another structure of the connecting portion of the probe according to the modified example of the first embodiment.
[FIG. 9] FIG. 9 is a schematic diagram illustrating a configuration of a probe according to a second embodiment.
[FIG. 10] FIG. 10 is a schematic diagram illustrating a configuration of a base end portion of a probe according to a modified example of the second embodiment.
[FIG. 11] FIG. 11 is a schematic diagram illustrating a configuration of an electrical connection device according to another embodiment.

### DESCRIPTION OF EMBODIMENTS

Next, embodiments of the present invention will be described with reference to the drawings. In the following description of the drawings, the same or similar parts are denoted by the same or similar reference numerals. It should be noted, however, that the drawings are schematic and ratios of thicknesses of respective parts are different from actual ones. Moreover, it is a matter of course that parts having different dimensional relationships and ratios are also included between the drawings. The embodiments illustrated below exemplify devices and methods for embodying the technical idea of the present invention, and the embodiments of the present invention do not limit the material, shape, structure, arrangement, and the like of the constituent parts to those described below.

### (First Embodiment)

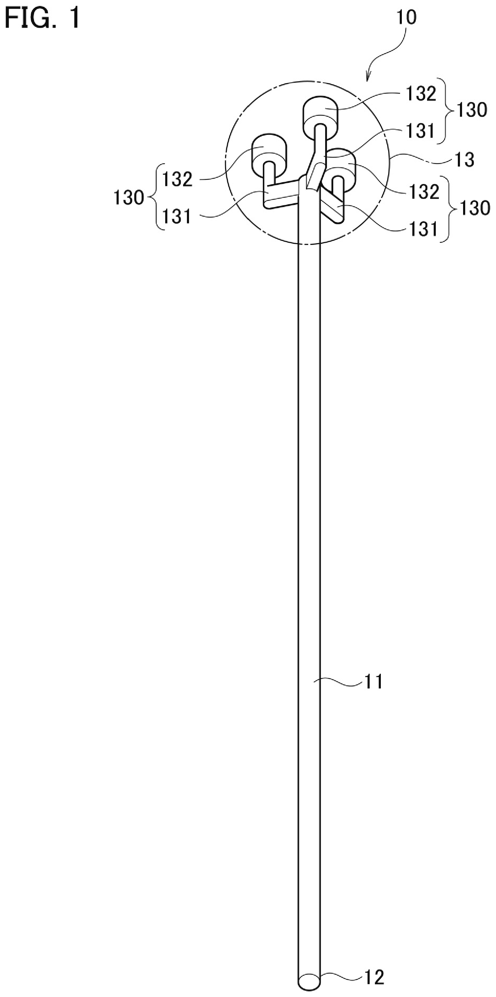

A probe 10 according to a first embodiment illustrated in FIG. 1 is used for inspection of electrical characteristics of an inspection object. The probe 10 includes a columnar body portion 11 extending in an axial direction, a tip portion 12 connected to one end of the body portion 11 and coming into contact with an inspection object in inspection, and a base end portion 13 connected to the other end of the body portion 11. Hereinafter, the axial direction of the body portion 11 is also simply referred to as "axial direction". As illustrated in FIG. 1, the body portion 11 and the tip portion 12 may be integrally formed. The base end portion 13 includes a plurality of connection portions 130. Each of the connection portions 130 has a connecting portion 131 with elasticity and connected to the body portion 11, and a contact portion 132 connected to the connecting portion 131.

Hereinafter, a direction in which the base end portion 13 is positioned as viewed from the tip portion 12 along the axial direction is defined as upward, and a direction in which the tip portion 12 is positioned as viewed from the base end portion 13 is defined as downward. For example, the contact portions 132 are positioned above the connecting portion 131. In addition, a surface of each portion of the probe 10 facing upward is defined as an upper surface, a surface facing downward is defined as a lower surface, and a surface connecting the upper surface and the lower surface is defined as a side surface.

Although in the probe 10 illustrated in FIG. 1, the base end portion 13 is provided in three connection portions 130, the number of connection portions 130 provided in the base end portion 13 may be two, or may be four or more. Hereinafter, a case where the base end portion 13 is provided in three connection portions 130 as illustrated in FIG. 1 will be described as an example.

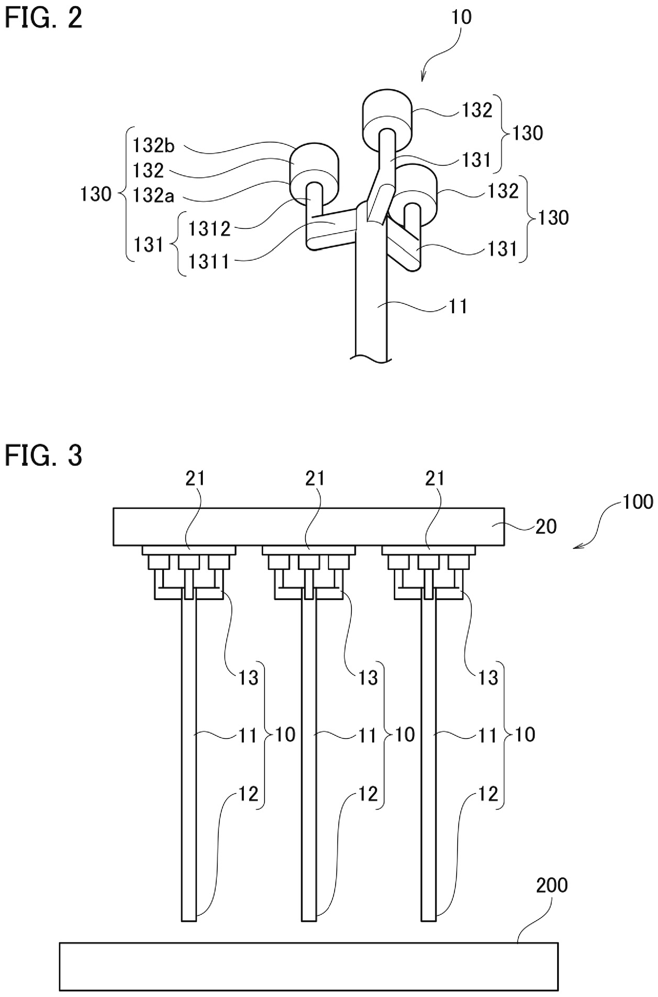

As illustrated in FIG. 2, the connecting portion 131 includes a beam portion 1311 connected to the body portion 11 and extending in a direction perpendicular to the axial direction, and a support portion 1312 connected to the beam portion 1311 and extending in the axial direction. The first end 132a of the contact portion 132 is connected to the support portion 1312 of the connecting portion 131. The contact portion 132 extends parallel to the axial direction. When viewed from the axial direction, the body portion 11 and the contact portion 132 are disposed apart from each other. The second end 132b of the contact portion 132 is included in a planar level perpendicular to the axial direction at the position extended in the axial direction from the position of the other end of the body portion 11 to which the base end portion 13 is connected. As will be described later, the second end 132b of the contact portion 132 comes into contact with a land in the inspection of an inspection object. The contact between the land and the probe 10 becomes more stable as the diameter of the contact portion 132 increases. Although an example has been illustrated in which the contact portion 132 has a larger diameter than the connecting portion 131, the contact portion 132 and the connecting portion 131 may have substantially the same diameter. In order to dispose the probes 10 at a narrow pitch, it is preferable for the diameter of the contact portion 132 to be small. Note that the end surface of the second end 132b of the contact portion 132 may be configured to remove an oxide film on the surface of the land. For example, unevenness may be formed on the end surface of the second end 132b.

The body portion 11 may have, for example, a circular shape or a polygonal shape in a cross section perpendicular to the axial direction (hereinafter, simply referred to as "cross section"). In the present embodiment, a case where the cross section of the body portion 11 has a circular shape will be described as an example. In order to electrically connect the electrode of the inspection object and the land, a conductive material such as a metal material is used for the probe 10. For example, nickel (Ni), nickel alloy, gold (Au), silver (Ag), copper (Cu), palladium (Pd), palladium alloy, rhodium (Rh), rhodium alloy, other noble metals, and the like may be used as the material of the probe 10.

The probe 10 is used, for example, in an electrical connection device 100 illustrated in FIG. 3. During the inspection of an inspection object 200, the tip portion 12 of the probe 10 comes into contact with an electrode pad (not illustrated) of the inspection object 200. The connection portion 130 of the base end portion 13 of the probe 10 is connected to a land 21 of a substrate 20. Specifically, the second end 132b of the contact portion 132 is connected to the land 21. As illustrated in FIG. 3, a plurality of contact portions 132 included in the same base end portion 13 are connected to one land 21. The other end of the body portion 11 is positioned below the second end 132b of the contact portion 132, and a space is interposed between the end of the body portion 11 and the substrate 20. The substrate 20 is, for example, a printed substrate or a space transformer. The land 21 is electrically connected to an inspection device such as an IC tester, which is not illustrated.

A tip of the second end 132b of the contact portion 132 may be a plane surface perpendicular to the axial direction of the probe 10. By forming the tip of the second end 132b as a plane surface, a contact area between the contact portion 132 and the land can be increased. A larger current can flow through the probe 10 as the contact area between the contact portion 132 and the land increases.

The electrical connection device 100 may be configured by bonding the base end portion 13 of the probe 10 to the land 21. A connection method and a connection material for bonding the probe 10 to the land 21 can be optionally selected. For example, the second end 132b of the contact portion 132 of the probe 10 may be bonded to the land 21 by soldering.

Since the connecting portion 131 of the connection portion 130 has elasticity, elastic deformation of the probe 10 along the axial direction is possible when bringing the tip portion 12 of the probe 10, in a state where the base end portion 13 is connected to the land 21, into contact with the inspection object 200. In other words, although the body portion 11 of the probe 10 is linear and thus does not have elasticity in the axial direction by itself, the probe 10 as a whole has elasticity in the axial direction. Therefore, after bringing the probe 10 into contact with the inspection object 200, an overdrive can be applied so as to press the probe 10 against the inspection object 200. The overdrive can ensure the electrical connection between the probe 10 and the inspection object 200. Further, since the base end portion 13 of the probe 10 has a plurality of contact portions 132, the probe 10 can be stably brought into contact with the land 21.

After the inspection of the inspection object 200 is completed, the probe 10 is separated from the inspection object 200. The connecting portion 131 is formed so that it elastically deforms and returns to its original state after the probe 10 is separated from the inspection object 200. For example, the connecting portion 131 may be made elastic by making the diameter of the beam portion 1311 of the connecting portion 131 relatively smaller than that of the body portion 11. Alternatively, the connecting portion 131 may be made elastic by using, for the connecting portion 131, a material having lower rigidity than that of the body portion 11. Further, as will be described later, a slit may be provided in the connecting portion 131.

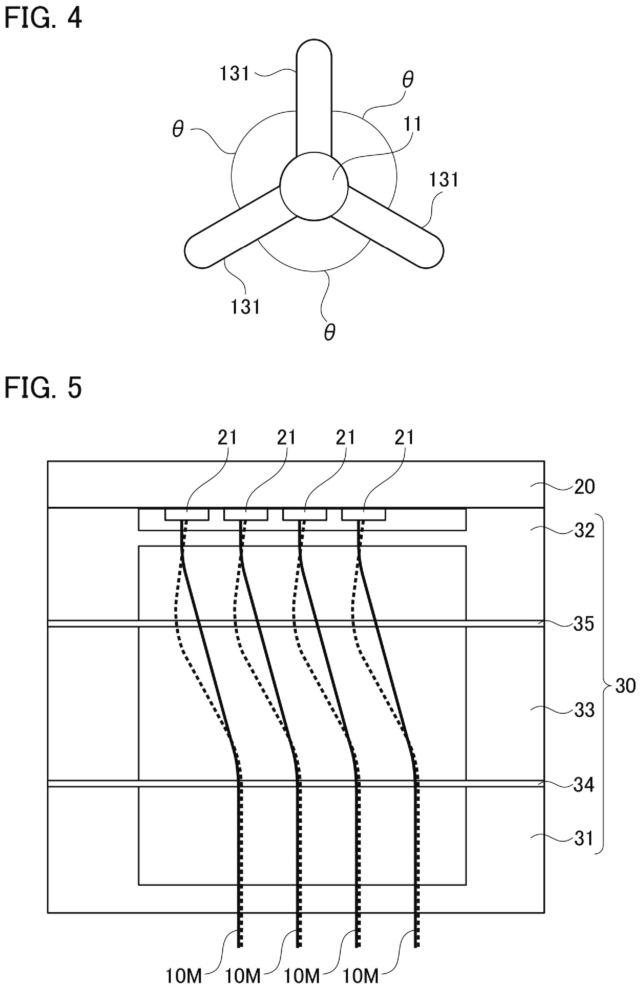

As illustrated in FIG. 4, an angle θ formed between adjacent connecting portions 131 may be the same for all of the adjacent connecting portions 131 when viewed from the axial direction of the probe 10. For example, when the base end portion 13 has three connection portions 130, the angle θ is approximately 120 degrees. By making the plurality of connecting portions 131 extend from the body portion 11 such that the angle formed between them is equal, the probe 10 can be stably brought into contact with the land 21. For example, the posture of the probe 10 can be maintained perpendicular to the surface of the substrate 20 on which the land 21 is disposed. In addition, the plurality of connection portions 130 of the base end portion 13 come into contact with the land 21 with equal pressing force.

Meanwhile, a probe of a comparative example (hereinafter referred to as "comparative probe 10M") in which one end of a columnar body portion is used as a tip portion that comes into contact with an inspection object and the other end is connected to a land at one point of a base end portion does not have elasticity in the axial direction in the probe itself. Therefore, for example, as in the electrical connection device of the comparative example illustrated in FIG. 5, an overdrive is applied by curving the body portion of the comparative probe 10M.

In the electrical connection device of the comparative example illustrated in FIG. 5, the comparative probe 10M is held by a probe head 30 having a bottom-side guide plate 31 and a top-side guide plate 32. The bottom-side guide plate 31 is disposed around the tip portion of the comparative probe 10M. The top-side guide plate 32 is disposed around the base end portion of the comparative probe 10M. The probe head 30 further has a first guide film 34 and a second guide film 35 that are disposed apart from each other in a space formed by interposing a spacer 33 between the top-side guide plate 32 and the bottom-side guide plate 31. The top-side guide plate 32 and the bottom-side guide plate 31 (hereinafter collectively referred to as "guide plates") are, for example, ceramic materials. The first guide film 34 and the second guide film 35 (hereinafter collectively referred to as "guide films") are, for example, resin films. The comparative probe 10M penetrates through guide holes (not illustrated) formed in the guide plates and the guide films.

In the probe head 30 illustrated in FIG. 5, with respect to the guide holes through which the same comparative probe 10M penetrates, an offset arrangement is made in which the position of the guide hole of the top-side guide plate 32 is shifted parallel to the main surface of the bottom-side guide plate 31 with respect to the guide hole of the bottom-side guide plate 31. Due to the offset arrangement, as illustrated by the solid line in FIG. 5, the body portion of the comparative probe 10M is curved inside the probe head 30. That is, in the hollow region between the bottom-side guide plate 31 and the top-side guide plate 32, the comparative probe 10M is in a curved state due to elastic deformation.

Since the guide plates are arranged in an offset manner, when the tip portion of the comparative probe 10M comes into contact with the inspection object, the comparative probe 10M buckles in the hollow region. That is, in a contact state where the comparative probe 10M is in contact with the inspection object, the comparative probe 10M is further curved by deflection deformation as illustrated by the broken line in FIG. 5. Since the comparative probe 10M is further curved, the comparative probe 10M comes into contact with the inspection object 200 with a predetermined pressure.

However, in the electrical connection device of the comparative example illustrated in FIG. 5, friction occurs between the comparative probe 10M and the guide plates and guide films due to the deformation of the comparative probe 10M. As a result, problems occur such as the comparative probe 10M not being able to sufficiently come into contact with the land 21 or the inspection object, resulting in insufficient electrical conduction between the inspection object and the land 21.

In contrast, the probe 10 does not need to be held in a state where the body portion 11 is curved. That is, there is no friction between the probe 10 and the guide plates and guide films, and thus the electrical conduction between the inspection object 200 and the land 21 is stabilized.

As described above, the probe 10 according to the embodiment includes a plurality of connection portions 130 each having the contact portion 132 connected to the body portion 11 via the connecting portion 131. Therefore, according to the probe 10, the electrical connection between the inspection object 200 and the land 21 can be stabilized.

### <Modified Example>

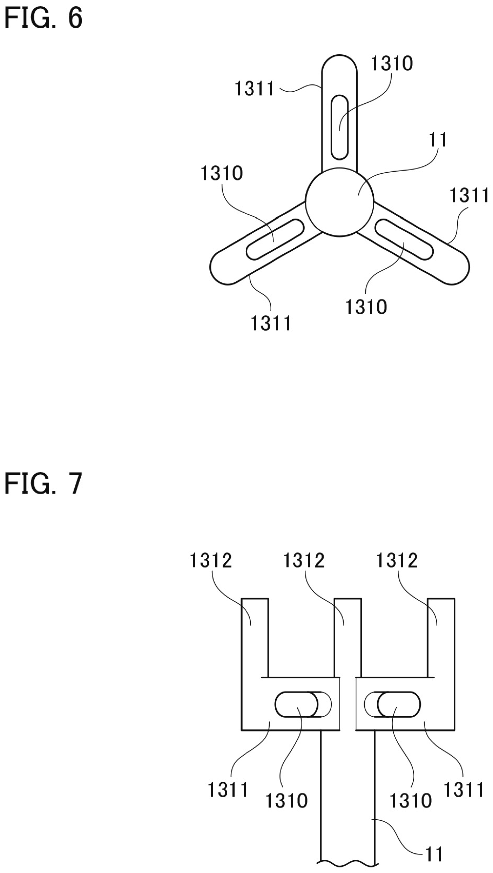

As illustrated in FIG. 6, in a probe 10 according to a modified example of the first embodiment, a slit 1310 penetrating through the connecting portion 131 in the beam portion 1311 in a direction parallel to the axial direction is formed in the connecting portion 131 of each of the plurality of connection portions 130. According to the probe 10 illustrated in FIG. 6, by providing the slit 1310 penetrating from the upper surface to the lower surface in the beam portion 1311 of each connecting portion 131, a needle pressure at which the probe 10 comes into contact with the inspection object 200 (hereinafter also simply referred to as "needle pressure") can be adjusted.

Further, as illustrated in FIG. 7, the slits 1310 penetrating through the connecting portions 131 in the beam portions 1311 in a direction perpendicular to the axial direction may be formed in the connecting portions 131. By providing the slits 1310 penetrating in the side surface direction in the beam portions 1311, the needle pressure can be adjusted.

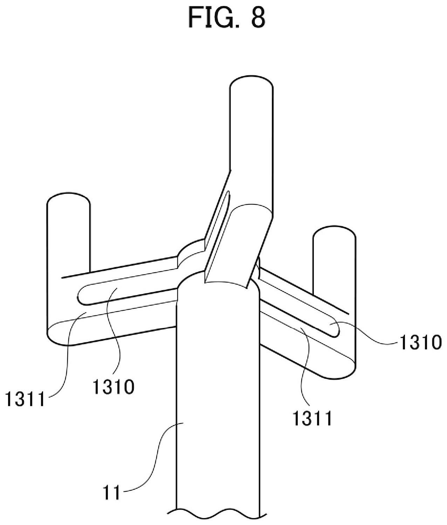

Alternatively, as illustrated in FIG. 8, the slits 1310 respectively formed in the beam portions 1311 of the plurality of connecting portions 131 may be in communication with each other at the portion where the connecting portion 131 is connected to the body portion 11. With the slits 1310 in communication with each other, the needle pressure can be adjusted by the plurality of connecting portions 131 as a whole.

### (Second Embodiment)

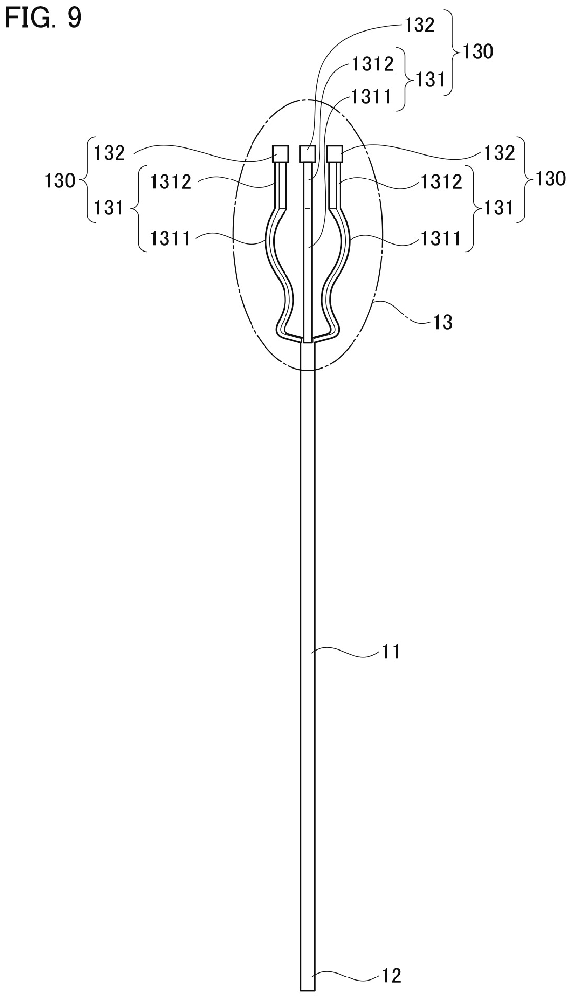

As illustrated in FIG. 9, in the probe 10 according to a second embodiment, the connecting portion 131 includes the beam portion 1311 that is connected to the body portion 11, and that has elasticity and is curved, and the support portion 1312 that connects the beam portion 1311 and the contact portion 132. The probe 10 illustrated in FIG. 9 differs from the probe 10 according to the first embodiment illustrated in FIG. 1 in that the connecting portion 131 includes a curved portion. As for the other configurations, the second embodiment is the same as the first embodiment.

In the probe 10 illustrated in FIG. 9, since the connecting portion 131 includes the curved portion, the connecting portion 131 is easily curved when the probe 10 comes into contact with the inspection object. Therefore, according to the probe 10 illustrated in FIG. 9, the overdrive can be applied more strongly. As a result, the probe 10 can be brought into contact with the inspection object more stably. Otherwise, the probe 10 according to the second embodiment is substantially the same as in the first embodiment, and redundant description is omitted.

### <Modified Example>

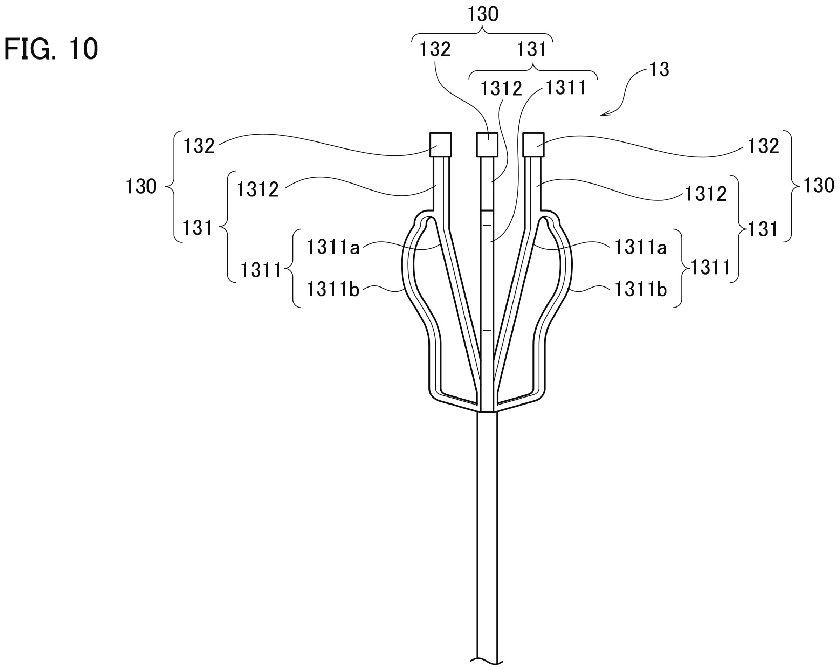

In a modified example of the probe 10 according to the second embodiment, as illustrated in FIG. 10, the connecting portion 131 includes a first arm 1311a and a second arm 1311b. The first arm 1311a and the second arm 1311b are disposed in parallel and are each connected to the body portion 11. The first arm 1311a linearly extends at an angle obliquely intersecting the axial direction in a direction away from the body portion 11. The second arm 1311b has a curved portion with elasticity. The support portion 1312 is connected to a joining portion where the first arm 1311a and the second arm 1311b are joined with each other.

In the probe 10 illustrated in FIG. 10, since the second arm 1311b has a curved portion with elasticity, the connecting portion 131, which curves when the probe 10 comes into contact with the inspection object, has greater elasticity. As a result, the overdrive can be applied more strongly. Although FIG. 10 illustrates an example in which the connecting portion 131 includes the first arm 1311a and the second arm 1311b, the connecting portion 131 may be configured by three or more arms including at least one arm having a curved portion with elasticity.

### (Other Embodiments)

Although the present invention has been described by the embodiments as described above, the description and drawings forming a part of this disclosure should not be understood as limiting the present invention. Various alternative embodiments, examples, and operational techniques will be apparent to those skilled in the art from this disclosure.

For example, although the case where the number of connection portions 130 constituting the base end portion 13 is three has been described as an example above, the number of connection portions 130 constituting the base end portion 13 may be two. The probes 10 can be disposed closer to each other as the number of connection portions 130 becomes smaller. Further, the number of connection portions 130 constituting the base end portion 13 may be three or more. The allowable value of current flowing through the probe 10 can be set higher as the number of connection portions 130 becomes larger.

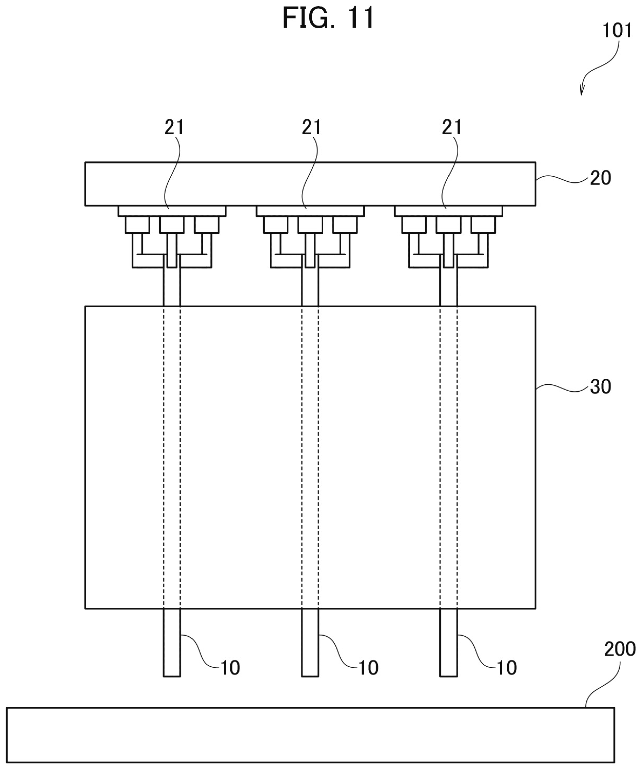

Although the electrical connection device 100 has been described above in which the contact portion 132 of the probe 10 is bonded to the land 21, the electrical connection device may be configured such that the contact portion 132 and the land 21 can freely come into contact with and separate from each other. For example, the probe 10 may be held by the probe head 30 as in the electrical connection device 101 illustrated in FIG. 11. The probe head 30 may include a guide plate having a plurality of guide holes through which the probes 10 respectively penetrate. The probe head 30 holds the probes 10 in a state where each of the plurality of probes 10 penetrates through a different guide hole. Therefore, adjacent probes 10 can be prevented from coming into contact with each other. Further, by holding the probe 10 with the probe head 30, the contact portion 132 of the probe 10 does not need to be bonded to the land 21. Since the contact portion 132 is not bonded to the land 21, for example, when a defect occurs in the probe 10, the probe 10 can be easily replaced. Further, a stopper having an outer diameter larger than the inner diameter of the guide hole may be formed on the probe 10. When the stopper is hooked on the periphery of the opening of the guide hole of the probe head 30, the probe 10 can be prevented from falling out of the probe head 30.

As described above, it is a matter of course that the present invention includes various embodiments and the like not described above.

The entire contents of Japanese Patent Application No. 2023-209330 (filing date: December 12, 2023) are incorporated herein by reference.

## Claims

1. A probe used for inspection of electrical characteristics of an inspection object, comprising:
a columnar body portion extending in an axial direction;
a tip portion connected to one end of the body portion and coming into contact with the inspection object in the inspection; and
a base end portion connected to the other end of the body portion, wherein
the base end portion comprises a plurality of connection portions each having a connecting portion with elasticity and connected to the body portion, and a contact portion having a first end connected to the connecting portion.

2. The probe according to claim 1, wherein a second end of the contact portion is included in a planar level perpendicular to the axial direction at a position extended in the axial direction from a position of the other end of the body portion.

3. The probe according to claim 1 or 2, wherein a slit penetrating through the connecting portion in a direction parallel to the axial direction is formed in the connecting portion.

4. The probe according to claim 1 or 2, wherein a slit penetrating through the connecting portion in a direction perpendicular to the axial direction is formed in the connecting portion.

5. The probe according to claim 4, wherein the slits of the plurality of connecting portions are in communication with each other at a portion where the connecting portions are connected to the body portion.

6. The probe according to claim 1 or 2, wherein
the connecting portion has a portion extending in a direction perpendicular to the axial direction, and
the contact portion extends parallel to the axial direction.

7. The probe according to claim 1 or 2, wherein the connecting portion includes a curved portion with elasticity.

8. The probe according to claim 1 or 2, wherein the connecting portion includes a first arm and a second arm disposed in parallel with the first arm.

9. The probe according to claim 8, wherein
the first arm linearly extends at an angle obliquely intersecting the axial direction in a direction away from the body portion, and
the second arm includes a curved portion with elasticity.

10. The probe according to claim 1 or 2, wherein an angle formed between adjacent connecting portions is the same for all of the adjacent connecting portions when viewed from the axial direction.
